# FASCICULE DE BREVET EUROPEEN

(11) **EP 1 423 917 B1**
(45) Date de publication et mention de la délivrance du brevet: **14.12.2011**
(21) Numéro de dépôt: 02767448.0
(22) Date de dépôt: 28.08.2002
(51) Int. Cl.: H03K 17/96, G01R 27/26

(54) **CAPTEUR DE PRESENCE**
ANWESENHEITSSENSOR
PRESENCE SENSING DEVICE

(30) Priorité: 30.08.2001 FR 0111395
(43) Date de publication de la demande: 02.06.2004
(73) Titulaire: VALEO ELECTRONIQUE, 94042 Creteil (FR)
(72) Inventeur: MUSAT, Ciprian, F-94000 Créteil (FR)
(74) Mandataire: Jacquot, Ludovic R. G.
(86) Numéro de dépôt international: PCT/EP2002/009595
(87) Numéro de publication internationale: WO 2003/021782

(56) Documents cités:
- WO-A-00/31553
- DE-A- 3 413 849
- US-A- 4 039 940

## Description

La présente invention concerne une poignée d'ouvrant de véhicule automobile comprenant un capteur de présence de type capacitif. Un capteur de ce type mesure la variation de capacitance d'une électrode pour détecter l'approche ou le toucher d'une personne.

La présente invention concerne plus particulièrement un capteur capacitif disposé en regard d'une surface conductrice.

L'invention peut être appliquée à un capteur capacitif dit d'approche ou dit tactile. Classiquement, un capteur capacitif, dit tactile, détecte le toucher d'une personne. Un capteur capacitif, dit d'approche, détecte l'approche d'une personne. Ces deux sortes de capteurs fonctionnent de manière similaire. Simplement, le capteur d'approche a une sensibilité plus élevée.

Afin de mieux illustrer l'invention de la demanderesse, on a choisi de représenter un capteur capacitif connu et de présenter ses inconvénients.

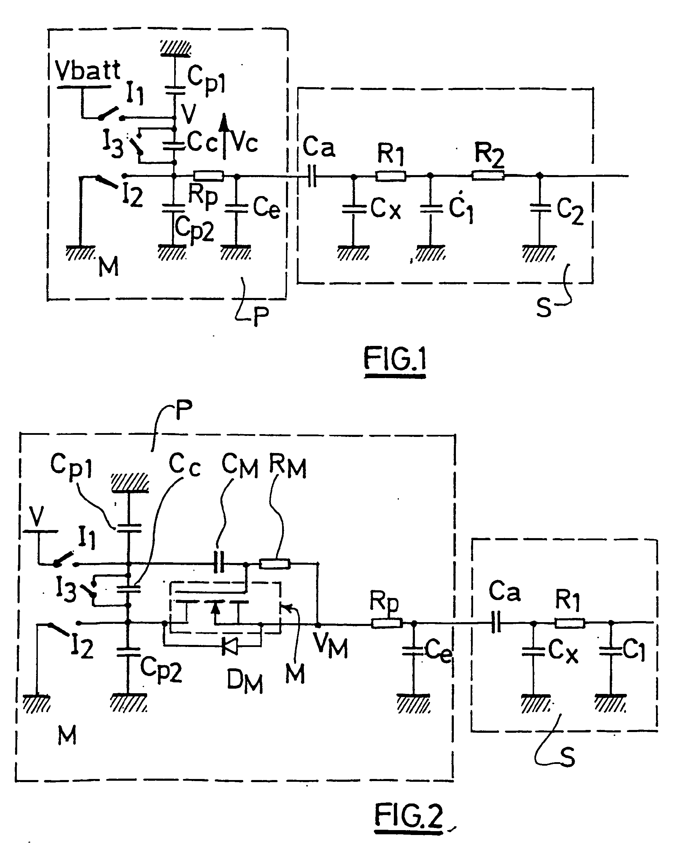

Ainsi, la figure 1 représente une modélisation schématique d'un capteur capacitif P selon l'art antérieur disposé en regard d'une surface conductrice S.

Typiquement, un capteur capacitif comporte une capacité de charge Cc de capacitance connue en série avec une électrode de capacité Ce. Ces capacités Cc et Ce sont reliées à une alimentation Vbatt par l'intermédiaire d'un interrupteur de charge 11. De plus, deux capacités dites parasites Cp1 et Cp2 , résultant de la construction du circuit, sont reliées d'une part à la capacité de charge Cc et d'autre part à une masse M. Par ailleurs, l'ensemble de ces capacités est relié à une masse M par l'intermédiaire d'un interrupteur de décharge 12. Une résistance Rp, correspondant à diverses résistances induites par le circuit, est disposée entre la capacité de charge Cc et la capacité de l'électrode Ce. En outre, un interrupteur 13 permet de court-circuiter la capacité de charge Cc.

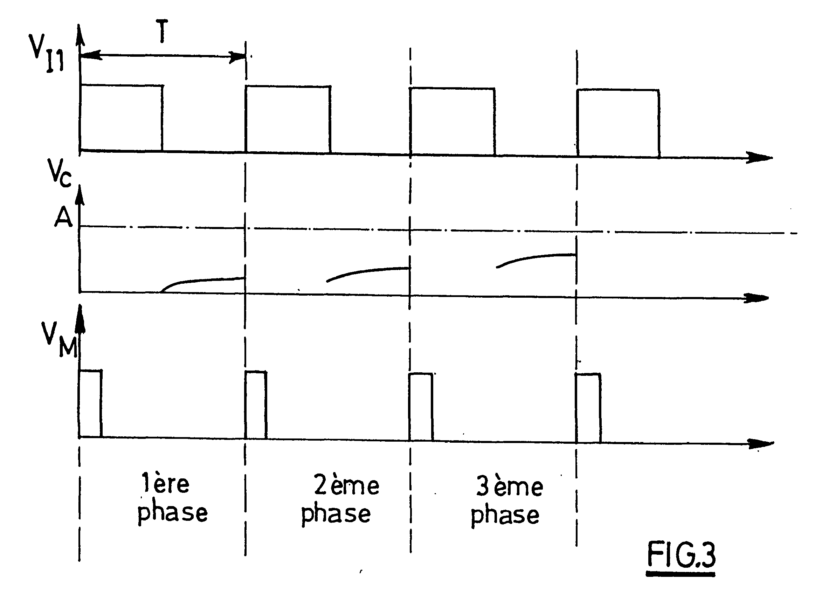

On connaît, notamment par document WO 00/31553, des capteurs capacitifs qui fonctionnent selon un principe de comptage du nombre de phases dans un cycle de chargement de la capacité de charge Cc. Pendant la durée d'un cycle, l'interrupteur I3 est ouvert. Les interrupteurs de charge 11 et de décharge 12 se ferment et s'ouvrent périodiquement avec la même période T , par exemple égale à 4 micro-secondes. Cependant, ces deux interrupteurs sont toujours en opposition, c'est-à-dire, lorsque l'interrupteur de charge I1 est ouvert, l'interrupteur de décharge I2 est fermé. La figure 3 représente la tension VI1 à la sortie de l'interrupteur de charge I1. Elle présente un rapport cyclique de un demi.

Dans une première phase, l'interrupteur de charge I1 est fermé et l'interrupteur de décharge I2 est ouvert. Les capacités de faible capacitance Cp1, Cp2, et Ce, d'une capacitance d'environ 10 pico-farads, se chargent. La capacité de charge Cc ne se charge pas car elle présente une capacitance bien supérieure à la capacitance des capacités Cp1, Cp2, et Ce. En effet, les capacités parasites ainsi que la capacité de l'électrode présentent une capacitance d'une dizaine de pico-farad tandis que la capacité de charge possède une capacitance dizaine de nano-farads. De plus, le temps de charge, égale à T/2, est trop court pour charger la capacité de charge Cc. Le premier graphe de la figure 3 montre la tension à la sortie de l'interrupteur de charge Vi1.

Dans une seconde phase, l'interrupteur de charge I1 est ouvert et l'interrupteur de décharge 12 est fermé, les charges accumulées dans les capacités Cp1, Cp2 et Ce se déchargent dans la capacité de charge Cc. Ainsi, comme visible sur la figure 3, la tension Vc aux bornes de la capacité de charge Cc augmente à chaque phase de décharge des capacités Cp1, Cp2 et Ce.

Les phases de charge et de décharge des capacités Cp1, Cp2, Ce se succèdent ainsi jusqu'à ce que la tension Vc, aux bornes de la capacité de charge Cc, ait atteint une valeur seuil A. Alors, l'interrupteur 13 est fermé, la capacité de charge Cc se décharge et un nouveau cycle de comptage commence.

Au cours de chaque cycle, un microcontrôleur compte et mémorise le nombre de phases de charge des capacités Cp1, Cp2, Ce nécessaire à atteindre la valeur seuil A.

Lorsqu'un utilisateur s'approche ou touche la surface de détection en regard de l'électrode, une capacité supplémentaire Cx est ajoutée en parallèle aux capacités Cp1, Cp2 et Ce. Dans ce cas, le nombre de phases de charge sera inférieur au nombre de phases de charge compté au cours du cycle précédent.

Ainsi, quand le microcontrôleur observe une variation, en valeur absolue, du nombre de phases de chargement de la capacité de charge Cc, il génère un signal de détection de la présence d'un individu.

Cependant, lorsqu'une surface conductrice est disposée au-dessus de l'électrode du capteur capacitif, la sensibilité du capteur capacitif est fortement diminuée. En conséquence, la présence d'un individu n'est pas toujours détectée. Ceci est particulièrement gênant, notamment dans un système de verrouillage/déverrouillage d'un véhicule de type mains-libres. Dans un système de ce type, l'électrode du capteur capacitif est disposée dans la poignée d'un ouvrant de sorte que, lorsqu'un utilisateur s'approche de la poignée, le capteur détecte sa présence et déclenche un procédé d'identification de l'utilisateur.

Cependant, lorsque la poignée est recouverte d'un apprêt conducteur, facilitant le procédé de peinture de la poignée, l'électrode ne détecte plus la présence d'un utilisateur et ne déclenche pas le procédé d'identification et de déverrouillage du véhicule.

Généralement, une surface conductrice S, telle qu'un apprêt ou une pellicule d'eau peut être schématiquement représentée par un réseau composé de nombreux circuits RC en parallèle, dans lequel les résistances sont non nulles. Ainsi, comme illustré sur la figure 1, une surface conductrice S recouvrant la poignée est représenté par le réseau R1C1, R2C2 ,etc.

De plus, la capacité Ca représente la capacité formée par la surface de l'électrode et la surface conductrice de la poignée.

Lors du procédé de comptage des phases de charge des capacités Cp1, Cp2 et Ce, toutes les capacités Ca, C1, C2,... de la surface conductrice vont également être chargées et déchargées.

En conséquence, compte tenu du grand nombre de ces capacités, une mesure précise de l'apparition d'une capacité supplémentaire Cx, correspondant à la présence d'une main autour de la poignée ou au toucher d'un doigt, ne pourra plus être détectée.

En outre, la zone de détection de la main de l'utilisateur n'est plus clairement délimitée car le champ électromagnétique émis par l'électrode s'étale sur toute la surface peinte de la poignée. De plus, son intensité est fortement diminuée.

Or, généralement, on souhaite avoir une zone de détection précisément délimitée. Ainsi, par exemple dans un système d'accès de type mains-libres, un capteur d'approche, disposé sur la face cachée de la poignée, détecte le mouvement d'ouverture de la portière. Et, un capteur tactile, disposé sur la face visible de la poignée, détecte le toucher d'un doigt pour obtenir le verrouillage du véhicule. Lorsque ces zones ne sont plus clairement définies, l'unité centrale du véhicule confond ces deux demandes.

Un but de la présente invention est donc de fournir un capteur capacitif peu coûteux et de faible encombrement permettant la détection d'un individu dans une région précise d'une surface conductrice.

A cet effet, l'invention a pour objet une poignée d'ouvrant de véhicule automobile selon la revendication 1.
Le capteur de présence selon l'invention peut comporter en outre une ou plusieurs des caractéristiques suivantes :
- la capacité de mesure Cm comporte un ensemble capacitif comprenant :
   - une première capacité Ce formée par une électrode,
   - une deuxième capacité Ca formée par ladite surface conductrice et ladite électrode,
   - une troisième capacité Cx formée par ladite surface conductrice et un utilisateur.
- la durée t1 est comprise entre 50 et 200 nano-secondes et, est de préférence, égale à 100 nano-secondes.
- il comporte un moyen de commande de l'ouverture et de la fermeture du commutateur.
- le moyen de commande de l'ouverture et de la fermeture comporte un circuit RmCm composé d'une résistance et d'une capacité en série, alimenté par la tension cyclique V.
- une diode Dm est reliée en parallèle au commutateur C de sorte que les capacités Ca, Ce, Cx de l'ensemble capacitif sont aptes à se décharger dans la capacité de charge Cc.
- le commutateur est un composant MOSFET.
- la diode Dm est formée par le composant MOSFET.
La présente invention a également pour but un système de verrouillage/déverrouillage d'un véhicule automobile, caractérisé en ce qu'il comporte une poignée d'ouvrant telle que précédemment décrit.

L'invention sera mieux comprise au cours de la description explicative détaillée qui va suivre en référence:
- à la figure 1 qui représente une vue schématique d'un capteur capacitif disposé en regard d'une surface conductrice selon l'art antérieur,
- à la figure 2 qui représente une vue schématique d'un capteur capacitif disposé en regard d'une surface conductrice selon la présente invention,
- à la figure 3 qui représente schématiquement la variation de la tension en différents points du circuit.

La présente invention va à présent être décrite en liaison avec la figure 2. Les composants électroniques du capteur capacitif, identiques aux composants électroniques selon la présente invention, gardent les mêmes références.

Selon la présente invention, un commutateur M est disposé entre la capacité de charge Cc et la capacité de l'électrode Ce. Ce commutateur M est fermé lorsque l'interrupteur de charge I1 est fermé. Cependant, la durée de fermeture t1 de ce commutateur M est très inférieure à la durée de fermeture T de l'interrupteur I1.

En particulier, la durée de fermeture t1 est égale au temps de chargement de l'ensemble capacitif Ce, Ca, Cx de sorte que les charges électriques n'ont pas le temps de se propager le long de la surface conductrice de la poignée.

La durée t1, pendant lequel le commutateur M est fermé, est comprise entre 50 et 200 nano-secondes et est, de préférence, égale à 100 nano-secondes.

Ce commutateur M est commandé par un moyen de commande, par exemple un circuit RmCm, composé d'une résistance Rm et d'une capacité Cm en série. Ce circuit est avantageusement relié à la sortie de l'interrupteur de charge I1 de sorte que la fermeture de l'interrupteur de charge I1 et du commutateur M est concomitante.

Ainsi, avantageusement, ce commutateur et son moyen de commande sont peu encombrants. De plus, ils permettent d'éviter l'utilisation d'un microcontrôleur de haute performance à coût élevé.

Selon la présente invention, ce commutateur M est un composant MOSFET

En outre, une diode Dm passante dans le sens des capacités Ce et Ca, est disposée aux bornes du commutateur C, de sorte que l'ensemble capacitif Ca, Ce et Cx est apte à se décharger sur la capacité de charge Cc.

Préférentiellement, on choisit un composant MOSFET permettant le passage des charges électriques pendant la phase de décharge des capacités Ce, Ca et Cx. Dans ce cas, la diode Dm n'est plus nécessaire au fonctionnement du capteur capacitif, de sorte que le capteur de présence est moins coûteux et plus compact. Le MOSFET joue alors le rôle d'interrupteur en phase de chargement des capacités Ce, Ca et Cx, et, de diode Dm en phase de déchargement de celles-ci.

## Revendications

1. Poignée d'ouvrant de véhicule automobile comprenant un capteur de présence (P) et une surface(S) conductrice, ledit capteur de présence (P) disposé en regard de ladite surface conductrice (S), comporte une capacité de mesure (Ce, Ca, Cx) dont la capacitance est apte à être modifiée suite à la détection de la présence d'un utilisateur, une capacité de charge (Cc) et une alimentation (V) apte à charger cycliquement, pendant des durées (T) prédéfinies, la capacité de charge (Cc) ainsi que la capacité de mesure (Ce, Ca, Cx) de manière à mesurer une modification de la capacitance de celle-ci, pour détecter la présence d'un utilisateur, **caractérisée en ce qu'**un commutateur (M) est interposé entre la capacité de charge (Cc) et la capacité de mesure (Ce, Ca, Cx) et **en ce qu'**il y a un moyen pour agencer le commutateur (M) de manière que sa durée de fermeture est une durée t1 égale au temps de chargement de la capacité de mesure (Ce, Ca, Cx) pour que les charges électriques fournies par l'alimentation (V) se propagent uniquement sur une zone limitée et prédéfinie de la surface conductrice (S).

2. Poignée, selon la revendication 1, **caractérisée en ce que** la capacité de mesure (Ce, Ca, Cx) comporte un ensemble capacitif comprenant:
- une première capacité (Ce) formée par une électrode,
- une deuxième capacité (Ca) formée par ladite surface conductrice (S) et ladite électrode (Ce),
- une troisième capacité (Cx) formée par ladite surface conductrice (S) et un utilisateur.

3. Poignée selon l'une des revendications 1 ou 2, **caractérisée en ce que** la durée t1 est comprise entre 50 et 200 nano-secondes et est, de préférence, égale à 100 nano-secondes.

4. Poignée selon l'une des revendications 1 ou 3, **caractérisée en ce qu'**il comporte un moyen de commande de l'ouverture et de la fermeture du commutateur (M).

5. Poignée selon la revendication 4, **caractérisée en ce que** le moyen de commande de l'ouverture et de la fermeture du commutateur (M) comporte un circuit (Rm Cm) composé d'une résistance et d'une capacité en série, alimenté par la tension cyclique (V).

6. Poignée selon l'une des revendications précédentes, **caractérisée en ce qu'**une diode (Dm) est reliée en parallèle au commutateur (M), de sorte que les capacités (Ca, Ce, Cx) de l'ensemble capacitif sont aptes à se décharger dans la capacité de charge (Cc).

7. Poignée selon l'une des revendications précédentes, **caractérisée en ce que** le commutateur (M) est un composant MOSFET.

8. Poignée selon la combinaison des revendications 6 et 7, **caractérisée en ce que** la diode (Dm) est formée par le composant MOSFET.

9. Système de verrouillage/déverrouillage d'un véhicule automobile **caractérisé en ce qu'**il comporte une poignée d'ouvrant selon l'une des revendications 1 à 8.

## Claims

1. Motor vehicle opening handle including a presence sensor (P) and a conductive surface (S), said presence sensor (P), arranged facing said conductive surface (S), comprises a measuring capacitor (Ce, Ca, Cx), the capacitance of which is designed to be modified following the detection of the presence of a user, a charge capacitor (Cc) and a power supply (V) suitable for cyclically charging, during predefined times (T), the charge capacitor (Cc) and the measuring capacitor (Ce, Ca, Cx) so as to measure a modification of the capacitance thereof, to detect the presence of a user, **characterized in that** a switch (M) is interposed between the charge capacitor (Cc) and the measuring capacitor (Ce, Ca, Cx) and **in that** there is a means for arranging the switch (M) so that its closure time is a time t1 equal to the charging time of the measuring capacitor (Ce, Ca, Cx) so that the electrical charges supplied by the power supply (V) are propagated only over a limited and predefined area of the conductive surface (S) .

2. Handle, according to Claim 1, **characterized in that** the measuring capacitor (Ce, Ca, Cx) comprises a capacitative assembly comprising:
- a first capacitor (Ce) formed by an electrode,
- a second capacitor (Ca) formed by said conductive surface (S) and said electrode (Ce),
- a third capacitor (Cx) formed by said conductive surface (S) and a user,

3. Handle according to one of Claims 1 or 2, **characterized in that** the time t1 is between 50 and 200 nanoseconds and is preferably equal to 100 nanoseconds.

4. Handle according to one of Claims 1 or 3, **characterized in that** it includes a means for controlling the opening and the closing of the switch (M).

5. Handle according to Claim 4, **characterized in that** the means for controlling the opening and the closing of the switch (M) comprises a circuit (Rm, Cm) consisting of a resistor and a capacitor in series, powered by the cyclical voltage (V).

6. Mandle according to one of the preceding claims, **characterized in that** a diode (Dm) is linked in parallel to the switch (M), so that the capacitors (Ca, Ce, Cx) of the capacitative assembly are designed to be discharged into the charge capacitor (Cc).

7. Handle according to one of the preceding claims, **characterized in that** the switch (M) is a MOSFET component.

8. Handle according to the combination of Claims 6 and 7, **characterized in that** the diode (Dm) is formed by the MOSFET component.

9. Motor vehicle locking/unlocking system, **characterized in that** it includes an opening handle according to one of Claims 1 to 8.

## Patentansprüche

1. Handgriff einer Öffnungseinrichtung eines Kraftfahrzeugs, der einen Anwesenheitssensor (P) und eine leitende Fläche (S) enthält, wobei der gegenüber der leitenden Fläche (S) angeordnete Anwesenheitssensor (P) einen Messkondensator (Ce, Ca, Cx), dessen Kapazität nach der Erfassung der Anwesenheit eines Benutzers verändert werden kann, einen Ladekondensator (Cc) und eine Versorgung (V) aufweist, die während vordefinierter Dauern (T) den Ladekondensator (Cc) sowie den Messkondensator (Ce, Ca, Cx) zyklisch laden kann, um eine Veränderung von dessen Kapazität zu messen, um die Anwesenheit eines Benutzers zu erfassen, **dadurch gekennzeichnet, dass** ein Schalter (M) zwischen den Ladekondensator (Cc) und den Messkondensator (Ce, Ca, Cx) eingefügt ist, und dass es eine Einrichtung gibt, um den Schalter (M) so zu gestalten, dass seine Schließdauer eine Dauer t1 gleich der Ladezeit des Messkondensators (Ce, Ca, Cx) ist, damit die von der Versorgung (V) gelieferten elektrischen Ladungen sich nur in einer begrenzten und vordefinierten Zone der leitenden Fläche (S) ausbreiten.

2. Handgriff nach Anspruch 1, **dadurch gekennzeichnet, dass** der Messkondensator (Ce, Ca, Cx) eine erste kapazitive Einheit aufweist, die enthält:
- einen ersten Kondensator (Ce), der von einer Elektrode gebildet wird,
- einen zweiten Kondensator (Ca), der von der leitenden Fläche (S) und der Elektrode (Ce) gebildet wird,
- einen dritten Kondensator (Cx), der von der leitenden Fläche (S) und einem Benutzer gebildet wird.

3. Handgriff nach einem der Ansprüche 1 oder 2, **dadurch gekennzeichnet, dass** die Dauer t1 zwischen 50 und 200 Nanosekunden liegt und vorzugsweise gleich 100 Nanosekunden ist.

4. Handgriff nach einem der Ansprüche 1 oder 3, **dadurch gekennzeichnet, dass** er eine Steuereinrichtung des Öffnens und Schließens des Schalters (M) aufweist.

5. Handgriff nach Anspruch 4, **dadurch gekennzeichnet, dass** die Steuereinrichtung des Öffnens und Schließens des Schalters (M) eine aus einem Widerstand und einem Kondensator in Reihe geschaltet bestehende Schaltung (R_{M}, C_{M}) aufweist, die von der zyklischen Spannung (V) gespeist wird.

6. Handgriff nach einem der vorhergehenden Ansprüche, **dadurch gekennzeichnet, dass** eine Diode (Dm) parallel mit dem Schalter (M) verbunden ist, so das die Kondensatoren (Ca, Ce, Cx) der kapazitiven Einheit sich in den Ladekondensator (Cc) entladen können.

7. Handgriff nach einem der vorhergehenden Ansprüche, **dadurch gekennzeichnet, dass** der Schalter (M) MOSFET-Bauteil ist.

8. Handgriff nach der Kombination der Ansprüche 6 und 7, **dadurch gekennzeichnet, dass** die Diode (Dm) vom MOSFET-Bauteil gebildet wird.

9. Verriegelungs-/Entriegelungssystem eines Kraftfahrzeugs, **dadurch gekennzeichnet, dass** es einen Handgriff einer Öffnungseinrichtung nach einem der Ansprüche 1 bis 8 aufweist.
